# EUROPEAN PATENT SPECIFICATION

(11) **EP 4 366 284 B1**
(45) Date of publication and mention of the grant of the patent: **05.11.2025**
(21) Application number: 23765434.8
(22) Date of filing: 15.09.2023
(51) Int. Cl.: H04M 1/02, H05K 1/14, G06F 1/16

(54) **ELECTRONIC DEVICE COMPRISING FIXING MEMBER**
ELEKTRONISCHE VORRICHTUNG MIT BEFESTIGUNGSELEMENT
DISPOSITIF ÉLECTRONIQUE COMPRENANT UN ÉLÉMENT DE FIXATION

(30) Priority: 15.09.2022 KR 20220116458; 28.10.2022 KR 20220140892
(43) Date of publication of application: 08.05.2024
(73) Proprietor: Samsung Electronics Co., Ltd., Suwon-si, Gyeonggi-do 16677 (KR)
(72) Inventor: LEE, Jeonghoon, Suwon-si, Gyeonggi-do 16677 (KR)
(74) Representative: HGF
(86) International application number: PCT/KR2023/013930
(87) International publication number: WO 2024/058608

(56) References cited:
- KR-A- 20170 125 071
- KR-A- 20220 017 322
- KR-A- 20220 036 219
- KR-A- 20220 102 321
- KR-A- 20220 118 146
- US-A1- 2009 168 384
- US-A1- 2021 104 712

## Description

### [Technical Field]

Embodiments of the disclosure relate to a fixing member for preventing a flexible circuit board from being separated or lifted, and to an electronic device including the same.

### [Background Art]

Advancing information communication technology and semiconductor technology accelerate the spread and use of various electronic devices. In particular, recent electronic devices are being developed to carry out communication while carried on. Further, electronic devices may output stored information as voices or images. As electronic devices are highly integrated, and high-speed or high-volume wireless communication becomes commonplace, an electronic device, such as a mobile communication terminal, is recently being equipped with various functions. For example, an electronic device comes with the integrated functionality, including an entertainment function, such as playing video games, a multimedia function, such as replaying music/videos, a communication and security function for mobile banking, and a scheduling and e-wallet function. These electronic devices have been downsized to be conveniently carried by users.

US 2021/104712 A1 and US 2009/168384 A1 disclose housings for electronic devices with a fixing member for a circuit board.

The above-described information may be provided as background for the purpose of helping understanding of the disclosure. No claim or determination is made as to whether any of the foregoing is applicable as background art in relation to the disclosure.

### [Disclosure of Invention]

### [Solution to Problems]

According to an embodiment of the disclosure, an electronic device may comprise a housing, an internal structure disposed in the housing, a fixing member including a first supporting area coupled to one surface of the internal structure and a second supporting area extending from the first supporting area and/or a flexible circuit board disposed to cross the one surface of the internal structure in a first direction. A portion of the flexible circuit board may pass through a passage formed between the second supporting area and the one surface of the internal structure.

### [Brief Description of Drawings]

FIG. 1 is a block diagram illustrating an electronic device in a network environment according to an embodiment of the disclosure;
FIG. 2 is a front perspective view illustrating an electronic device according to an embodiment of the disclosure;
FIG. 3 is a rear perspective view illustrating an electronic device according to an embodiment of the disclosure;
FIG. 4 is an exploded front perspective view illustrating the electronic device of FIG. 2, according to an embodiment of the disclosure;
FIG. 5 is a rear exploded perspective view illustrating the electronic device of FIG. 2 according to an embodiment of the disclosure;
FIG. 6 is a rear view illustrating a battery, a flexible circuit board, and a fixing member of an electronic device according to an embodiment of the disclosure;
FIG. 7 is a perspective view illustrating a battery, a flexible circuit board, and a fixing member of an electronic device according to an embodiment of the disclosure;
FIG. 8 is a plan view illustrating a fixing member according to an embodiment of the disclosure;
FIG. 9 is a perspective view illustrating a fixing member according to an embodiment of the disclosure;
FIG. 10 is a perspective view illustrating a battery, a flexible circuit board, and a fixing member of an electronic device according to an embodiment of the disclosure;
FIGS. 11 and 12 are rear views illustrating a battery, a flexible circuit board, and a fixing member of an electronic device according to an embodiment of the disclosure;
FIG. 13 is a rear view illustrating a battery, a flexible circuit board, and a fixing member of an electronic device according to an embodiment of the disclosure; and
FIG. 14 is a perspective view illustrating a battery, a flexible circuit board, and a fixing member of an electronic device according to an embodiment of the disclosure.

### [Mode for the Invention]

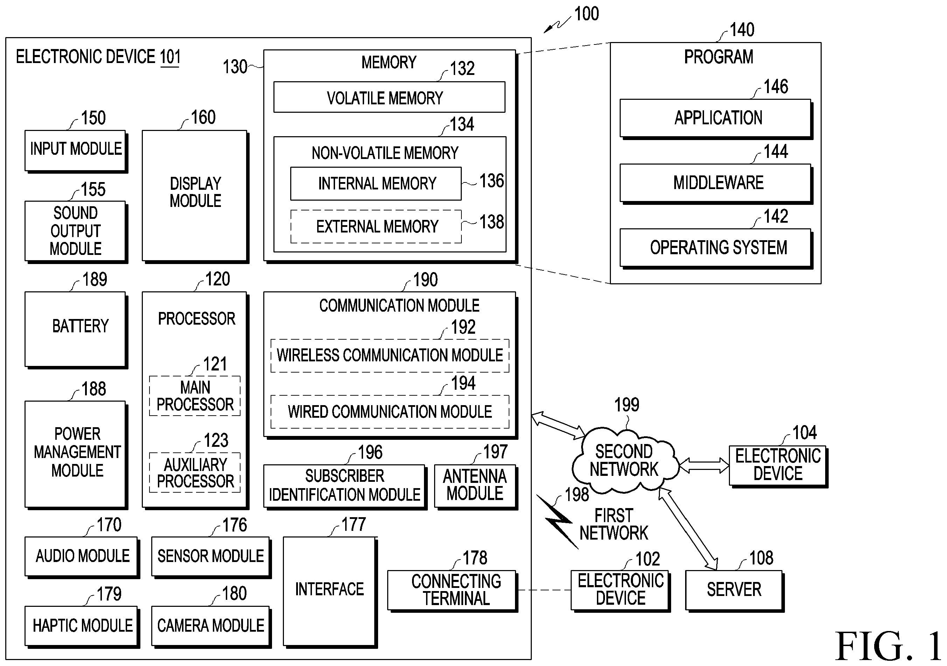

FIG. 1 is a block diagram illustrating an electronic device in a network environment according to an embodiment of the disclosure.

Referring to FIG. 1, the electronic device 101 in the network environment 100 may communicate with an electronic device 102 via a first network 198 (e.g., a short-range wireless communication network), or an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module (SIM) 196, or an antenna module 197. In an embodiment, at least one (e.g., the connecting terminal 178) of the components may be omitted from the electronic device 101, or one or more other components may be added in the electronic device 101. In an embodiment, some (e.g., the sensor module 176, the camera module 180, or the antenna module 197) of the components may be integrated into a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to an embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be configured to use lower power than the main processor 121 or to be specified for a designated function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. The artificial intelligence model may be generated via machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thereto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by other component (e.g., the processor 120) of the electronic device 101, from the outside (e.g., a user) of the electronic device 101. The input module 150 may include, for example, a microphone, a mouse, a keyboard, keys (e.g., buttons), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display 160 may include, for example, a display, a hologram device, or a projector and control circuitry to control a corresponding one of the display, hologram device, and projector. According to an embodiment, the display 160 may include a touch sensor configured to detect a touch, or a pressure sensor configured to measure the intensity of a force generated by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an accelerometer, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or motion) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to an embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device 104 via a first network 198 (e.g., a short-range communication network, such as Bluetooth^{™}, wireless-fidelity (Wi-Fi) direct, or infrared data association (IrDA)) or a second network 199 (e.g., a long-range communication network, such as a legacy cellular network, a 5G network, a next-generation communication network, the Internet, or a computer network (e.g., local area network (LAN) or wide area network (WAN)). These various types of communication modules may be implemented as a single component (e.g., a single chip), or may be implemented as multi components (e.g., multi chips) separate from each other. The wireless communication module 192 may identify or authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device). According to an embodiment, the antenna module 197 may include an antenna including a radiator formed of a conductor or conductive pattern formed on a substrate (e.g., a printed circuit board (PCB)). According to an embodiment, the antenna module 197 may include a plurality of antennas (e.g., an antenna array). In this case, at least one antenna appropriate for a communication scheme used in a communication network, such as the first network 198 or the second network 199, may be selected from the plurality of antennas by, e.g., the communication module 190. The signal or the power may then be transmitted or received between the communication module 190 and the external electronic device via the selected at least one antenna. According to an embodiment, other parts (e.g., radio frequency integrated circuit (RFIC)) than the radiator may be further formed as part of the antenna module 197.

According to an embodiment, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. The external electronic devices 102 or 104 each may be a device of the same or a different type from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In an embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or health-care) based on 5G communication technology or IoT-related technology.

In the following detailed description, a length direction, a width direction, and/or a thickness direction of the electronic device may be mentioned and may be defined as a 'Y-axis direction,' 'X-axis direction', and/or 'Z-axis direction,' respectively. In an embodiment, 'negative/positive (e.g., -/+)' may be mentioned together with the Cartesian coordinate system exemplified in the drawings with respect to the direction in which the component is oriented. For example, the front surface of the electronic device or housing may be defined as a 'surface facing in the +Z direction,' and the rear surface may be defined as a 'surface facing in the -Z direction'. In an embodiment, the side surface of the electronic device or housing may include an area facing in the +X direction, an area facing in the +Y direction, an area facing in the -X direction, and/or an area facing in the -Y direction. In another embodiment, the 'X-axis direction' may mean including both the '-X direction' and the '+X direction'. It should be noted that the directions are so defined with respect to the Cartesian coordinate system shown in the drawings for the sake of brevity of description, and the description of these directions or components do not limit an embodiment of the disclosure. For example, the direction in which the front surface or rear surface faces may be varied depending on the unfolded state or folded state of the electronic device, and the above-mentioned directions may be interpreted as different ones depending on the user's way to grip.

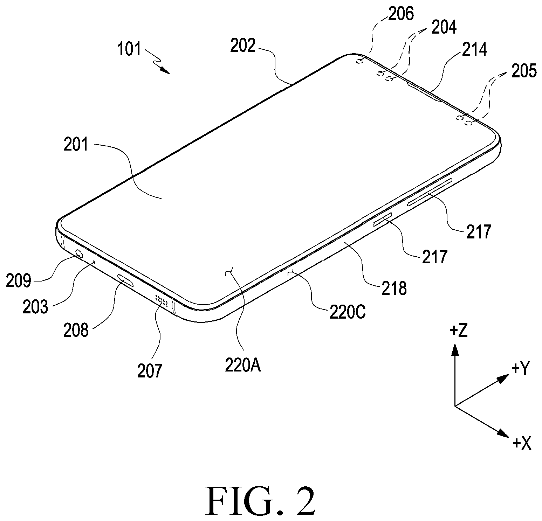

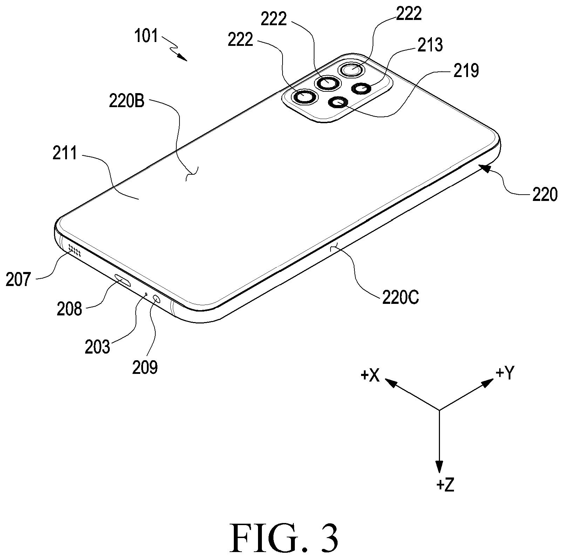

The configuration of the electronic device 101 of FIGS. 2 and 3 may be identical in whole or part to the configuration of the electronic device 101 of FIG. 1.

FIG. 2 is a front perspective view illustrating an electronic device 101 according to an embodiment of the disclosure. FIG. 3 is a rear perspective view illustrating a rear surface of the electronic device 101 of FIG. 2 according to an embodiment of the disclosure.

Referring to FIGS. 2 and 3, according to an embodiment, an electronic device 101 may include a housing 210 including a first surface (or front surface) 210A, a second surface (or rear surface) 210B, and a side surface 210C surrounding a space between the first surface 210A and the second surface 210B. According to an embodiment (not shown), the housing 210 may denote a structure forming the first surface 210A of FIG. 2, the second surface 210B of FIG. 3, and some of the side surfaces 210C. According to an embodiment, at least part of the first surface 210A may have a substantially transparent front plate 202 (e.g., a glass plate or polymer plate including various coat layers). The second surface 210B may be formed by a rear plate 211 that is substantially opaque. The rear plate 211 may be formed of, e.g., laminated or colored glass, ceramic, polymer, metal (e.g., aluminum, stainless steel (STS), or magnesium), or a combination of at least two thereof. The side surface 210C may be formed by a side structure (or "side bezel structure") 218 that couples to the front plate 202 and the rear plate 211 and includes a metal and/or polymer. In an embodiment, the rear plate 211 and the side structure 218 may be integrally formed together and include the same material (e.g., a metal, such as aluminum).

Although not shown, the front plate 202 may include area(s) that bend from at least a portion of an edge toward the rear plate 211 and seamlessly extend. In an embodiment, only one of the areas of the front plate 202 (or the rear plate 211), which bend to the rear plate 211 (or front plate 202) and extend may be included in one edge of the first surface 210A. According to an embodiment, the front plate 202 or rear plate 211 may be substantially flat and, in this case, may not include an area bending and extending. When an area bending and extending is included, the thickness of the electronic device 101 at the portion including the area bending and extending may be smaller than the thickness of the rest.

According to an embodiment, the electronic device 101 may include at least one of a display 201, audio modules 203, 107, and 114 (e.g., the audio module 170 of FIG. 1), sensor modules 204 and 119 (e.g., the sensor module 176 of FIG. 1), camera modules 205, 112, and 113 (e.g., the camera module 180 of FIG. 1), a key input device 217 (e.g., the input module 150 of FIG. 1), a light emitting device 206, and connector holes 208 and 109 (e.g., the connection terminal 178 of FIG. 1). In an embodiment, the electronic device 101 may exclude at least one (e.g., the key input device 217 or the light emitting device 206) of the components or may add other components.

The display 201 may be visually exposed through a significant portion of the front plate 202. In an embodiment, at least a portion of the display 201 may be visually exposed through the front plate 202 forming the first surface 210A, or through a portion of the side surface 210C. In an embodiment, the edge of the display 201 may be formed to be substantially the same in shape as an adjacent outer edge of the front plate 202. In an embodiment (not shown), the interval between the outer edge of the display 201 and the outer edge of the front plate 202 may remain substantially even to give a larger area of exposure the display 201.

In an embodiment (not shown), the screen display area of the display 201 may have a recess or opening in a portion thereof, and at least one or more of the audio module 214, sensor module 204, camera module 205, and light emitting device 206 may be aligned with the recess or opening. In an embodiment (not shown), at least one or more of the audio module 214, sensor module 204, camera module 205, fingerprint sensor (not shown), and light emitting device 206 may be included on the rear surface of the screen display area of the display 201. In an embodiment (not shown), the display 201 may be disposed to be coupled with, or adjacent, a touch detecting circuit, a pressure sensor capable of measuring the strength (pressure) of touches, and/or a digitizer for detecting a magnetic field-type stylus pen. In an embodiment, at least a portion of the sensor modules 204 and 119 and/or at least a portion of the key input device 217 may be disposed on the side surface 210C.

The audio modules 203, 107, and 114 may include a microphone hole 203 and speaker holes 207 and 114. A microphone for acquiring external sounds may be disposed in the microphone hole 203. In an embodiment, a plurality of microphones may be disposed to detect the direction of the sound. The speaker holes 207 and 114 may include an external speaker hole 207 and a phone receiver hole 214. In an embodiment, the speaker holes 207 and 114 and the microphone hole 203 may be implemented as a single hole, or speakers may be rested without the speaker holes 207 and 114 (e.g., piezo speakers).

The sensor modules 204 and 119 may generate an electrical signal or data value corresponding to an internal operating state or external environmental state of the electronic device 101. For example, the sensor modules 204 and 119 may include a first sensor module 204 (e.g., a proximity sensor) and/or a second sensor module (not shown) (e.g., a fingerprint sensor), which is disposed on the first surface 210A of the housing 210, and/or a third sensor module 219 and/or a fourth sensor module (e.g., a fingerprint sensor) disposed on the second surface 210B of the housing 210. The fingerprint sensor may be disposed on the second surface 210B or side surface 210C as well as the first surface 210A (e.g., the display 201) of the housing 210. The electronic device 101 may further include, e.g., at least one of a gesture sensor, a gyro sensor, an atmospheric pressure sensor, a magnetic sensor, an acceleration sensor, a grip sensor, a color sensor, an infrared (IR) sensor, a biometric sensor, a temperature sensor, a humidity sensor, or an illuminance sensor 204.

The camera modules 205, 112, and 113 may include a first camera device 205 disposed on the first surface 210A of the electronic device 101, and a second camera device 212 and/or a flash 213 disposed on the second surface 210B. The camera devices 205 and 112 may include one or more lenses, an image sensor, and/or an image signal processor. The flash 213 may include, e.g., a light emitting diode (LED) or a xenon lamp. In an embodiment, one or more lenses (an infrared (IR) camera, a wide-angle lens, and a telescopic lens) and image sensors may be disposed on one surface of the electronic device 101. In an embodiment, flash 213 may emit infrared light. The infrared light emitted by the flash 213 and reflected by the subject may be received through the third sensor module 219. The electronic device 101 or the processor of the electronic device 101 may detect depth information about the subject based on the time point when the infrared light is received from the third sensor module 219.

The key input device 217 may be disposed on the side surface 210C of the housing 210. In an embodiment, the electronic device 101 may exclude all or some of the above-mentioned key input devices 217 and the excluded key input devices 217 may be implemented in other forms, e.g., as soft keys, on the display 201. In an embodiment, the key input device may include the sensor module disposed on the second surface 210B of the housing 210.

The light emitting device 206 may be disposed on, e.g., the first surface 210A of the housing 210. The light emitting device 206 may provide, e.g., information about the state of the electronic device 101 in the form of light. In an embodiment, the light emitting device 206 may provide a light source that interacts with, e.g., the camera module 205. The light emitting device 206 may include, e.g., a light emitting diode (LED), an infrared (IR) LED, or a xenon lamp.

The connector holes 208 and 109 may include a first connector hole 208 for receiving a connector (e.g., a universal serial bus (USB) connector) for transmitting or receiving power and/or data to/from an external electronic device and/or a second connector hole 209 (e.g., an earphone jack) for receiving a connector for transmitting or receiving audio signals to/from the external electronic device.

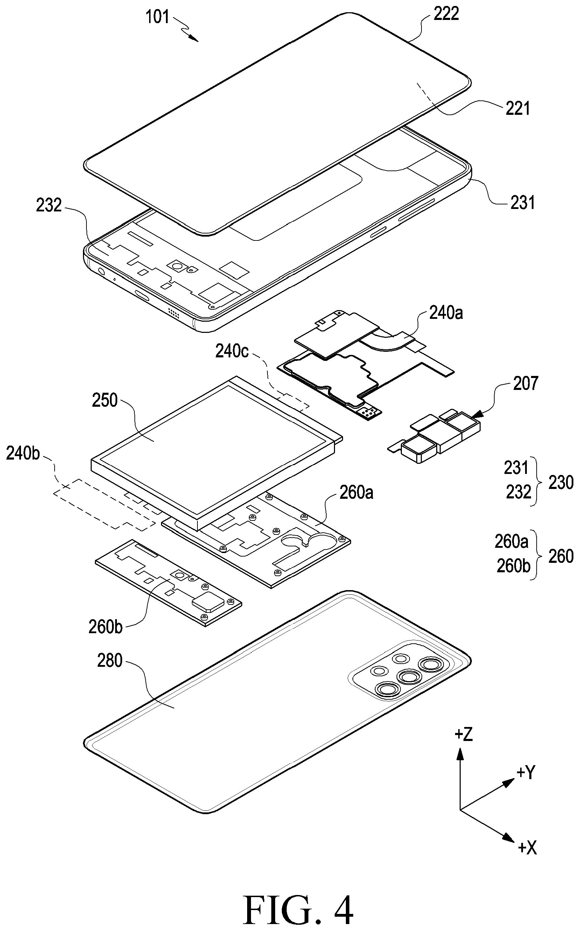

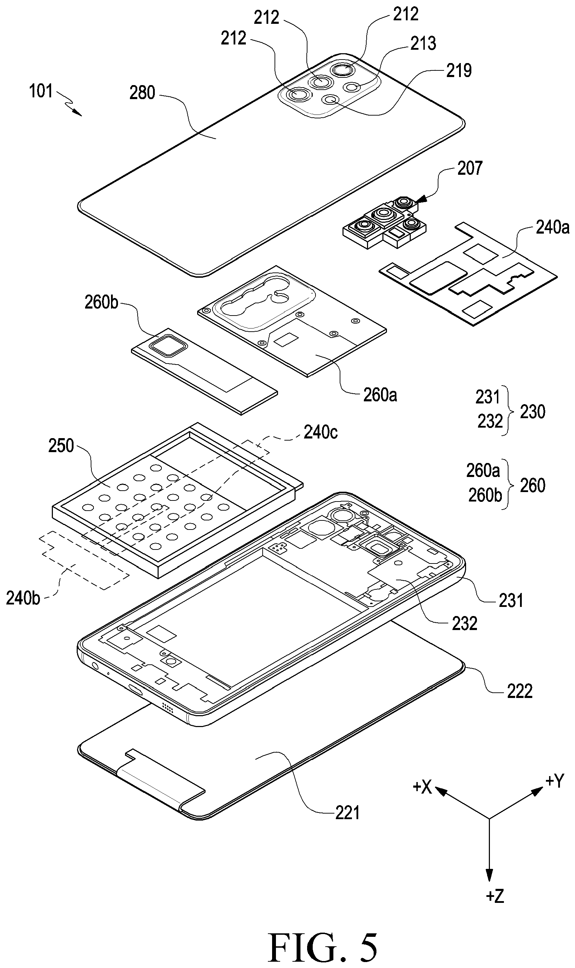

FIG. 4 is an exploded front perspective view illustrating the electronic device 101 of FIG. 2, according to an embodiment of the disclosure. FIG. 5 is a rear exploded perspective view illustrating the electronic device 101 of FIG. 2 according to an embodiment of the disclosure.

Referring to FIGS. 4 and 5, an electronic device 101 (e.g., the electronic device 101 of FIG. 1 and/or the electronic device 101 of FIG. 2 or 3) may include a side structure 231, a first supporting member 232 (e.g., a bracket), a front plate 222 (e.g., the front plate 202 of FIG. 2), a display 221 (e.g., the display 201 of FIG. 2), at least one printed circuit board (or board assembly) 240a and 240b, a battery 250 (e.g., the battery 189 of FIG. 1), a second supporting member 260 (e.g., a rear case), an antenna (not shown) (e.g., the antenna module 197 of FIG. 1), a camera assembly 215, and a rear plate 280 (e.g., the rear plate 211 of FIG. 3). When the plurality of printed circuit boards 240a and 240b are included, the electronic device 101 may include at least one flexible printed circuit board 240c (e.g. flexible substrate) to electrically connect different printed circuit boards. In other examples, at least one flexible printed circuit board 240c may connect a printed circuit board 240a and/or 240b and at least other internal structure or component of electronic deviece 101(e.g. electronic (or electrical) component). For example, the printed circuit boards 240a and 240b may include a first circuit board 240a disposed above the battery 250 and a second circuit board 240b disposed below the battery 250, and flexible printed circuit board 240c may electrically connect the first circuit board 240a and the second circuit board 240b.

According to an embodiment, the electronic device 101 may exclude at least one (e.g., the first supporting member 232 or the second supporting member 260) of the components or may comprise other components in addition to those described. At least one of the components of the electronic device 101 may be the same or similar to at least one of the components of the electronic device 101 of FIG. 2 or 3 and no duplicate description is made below.

At least a portion of the first supporting member 232 may be provided in a flat plate shape. In an embodiment, the first supporting member 232 may be disposed inside the electronic device 101 to be connected with the side surface structure 231 or formed integrally with the side surface structure 231. The first supporting member 232 may be formed of, e.g., a metallic material and/or non-metallic material (e.g., polymer). When at least partially formed of a metallic material, a portion of the side structure 231 or the first supporting member 232 may function as an antenna. The display 221 may be joined onto one surface of the first supporting member 232, and the printed circuit boards 240a and 240b may be joined onto the opposite surface of the first supporting member 311. A processor, memory, and/or interface may be mounted on the printed circuit boards 240a and 240b. The processor may comprise, without being limited to, one or more of, e.g., a central processing unit, an application processor, a graphic processing device, an image signal processing, a sensor hub processor, or a communication processor.

According to various embodiments, the first supporting member 232 and the side structure 231 may be collectively referred to as a front case or a housing 230. According to an embodiment, the housing 230 may be generally understood as a structure for receiving, protecting, or disposing the printed circuit boards 240a and 240b or the battery 250. In an embodiment, the housing 230 may be understood as including a structure that the user may visually or tangibly recognize from the exterior of the electronic device 101, e.g., the side structure 231, the front plate 222, and/or the rear plate 280. In an embodiment, the 'front or rear surface of the housing 230' may refer to the first surface 210A of FIG. 2 or the second surface 210B of FIG. 3. In an embodiment, the first supporting member 232 may be disposed between the front plate 222 (e.g., the first surface 210A of FIG. 2) and the rear plate 280 (e.g., the second surface 210B of FIG. 3) and may function as a structure for placing an electrical/electronic component (e.g. for supporting a component upon), such as the printed circuit boards 240a and 240b or the camera assembly 215. In the following description, as the camera module, a component receiving incident light through the second surface 210B of FIG. 3 may be exemplified, but the camera module 205 of FIG. 2 may also be disposed inside the electronic device through the configuration of the embodiment described below.

The memory may include, e.g., a volatile or non-volatile memory.

The interface may include, e.g., a high definition multimedia interface (HDMI), a universal serial bus (USB) interface, a secure digital (SD) card interface, and/or an audio interface. The interface may electrically or physically connect, e.g., the electronic device 101 with an external electronic device and may include a USB connector, an SD card/multimedia card (MMC) connector, or an audio connector.

The second supporting member 260 may include, e.g., an upper supporting member 260a and a lower supporting member 260b. In an embodiment, the upper supporting member 260a, together with a portion of the first supporting member 232, may be disposed to surround the printed circuit boards 240a and/or 240b. For example, the upper supporting member 260a among the second supporting members 260 may be disposed to face the first supporting member 232 with the first circuit board 240a interposed therebetween. In an embodiment, the lower supporting member 260b among the second supporting members 260 may face the first supporting member 232 with the second circuit board 240b interposed therebetween. A circuit device (e.g., a processor, a communication module (e.g., the communication module 190 of FIG. 1), or a memory) or various electrical/electronic components implemented in the form of an integrated circuit chip may be disposed on the printed circuit boards 240a and 240b. According to an embodiment, the printed circuit boards 240a and 240b may be provided with an electromagnetic shielding environment from the second supporting member 260. In an embodiment, the lower supporting member 260b may be utilized as a structure in which electrical/electronic components, such as a speaker module and an interface (e.g., a USB connector, an SD card/MMC connector, or an audio connector) may be disposed. In an embodiment, electrical/electronic components, such as a speaker module and an interface (e.g., a USB connector, an SD card/MMC connector, or an audio connector) may be disposed on an additional printed circuit board (not shown). In this case, the lower supporting member 260b, together with the other part of the first supporting member 232, may be disposed to surround the additional printed circuit board. The speaker module or interface disposed on the additional printed circuit board (not shown) or the lower supporting member 260b may be disposed corresponding to the audio module 207 or connector holes 208 and 109 of FIG. 2.

The battery 250 may be a device for supplying power to at least one component of the electronic device 101. The battery 450 may include, e.g., a primary cell which is not rechargeable, a secondary cell which is rechargeable, or a fuel cell. At least a portion of the battery 250 may be disposed on substantially the same plane as the printed circuit boards 240a and 240b. The battery 250 may be integrally or detachably disposed inside the electronic device 101.

Although not shown, the antenna may include a conductor pattern implemented on the surface of the second supporting member 260 through, e.g., laser direct structuring. In an embodiment, the antenna may include a printed circuit pattern formed on the surface of the thin film. The thin film-type antenna may be disposed between the rear plate 280 and the battery 250. The antenna may include, e.g., a near-field communication (NFC) antenna, a wireless charging antenna, and/or a magnetic secure transmission (MST) antenna. The antenna may perform short-range communication with, e.g., an external device or may wirelessly transmit or receive power necessary for charging. In an embodiment of the present invention, another antenna structure may be formed by a portion or combination of the side structure 231 and/or the first supporting member 232.

The camera assembly 215 may include at least one camera module, e.g., at least one of the plurality of camera modules shown in FIG. 5. Inside the electronic device 101, the camera assembly 215 may receive at least a portion of the light incident through the optical hole or the camera windows 212, 213, and 219. In an embodiment, the camera assembly 215 may be disposed on the first supporting member 232 in a position adjacent to the printed circuit boards 240a and 240b. In an embodiment, the camera module(s) of the camera assembly 215 may be generally aligned with either one of the camera windows 212, 213, and 219 and be a least partially surrounded by the second supporting member 260 (e.g., the upper supporting member 260a).

It should be noted that in the following detailed description, reference may be made to the electronic device 101 of the foregoing embodiments, and components, which may easily be understood through the foregoing embodiments, are assigned the same reference numerals or omitted and a description thereof may be omitted.

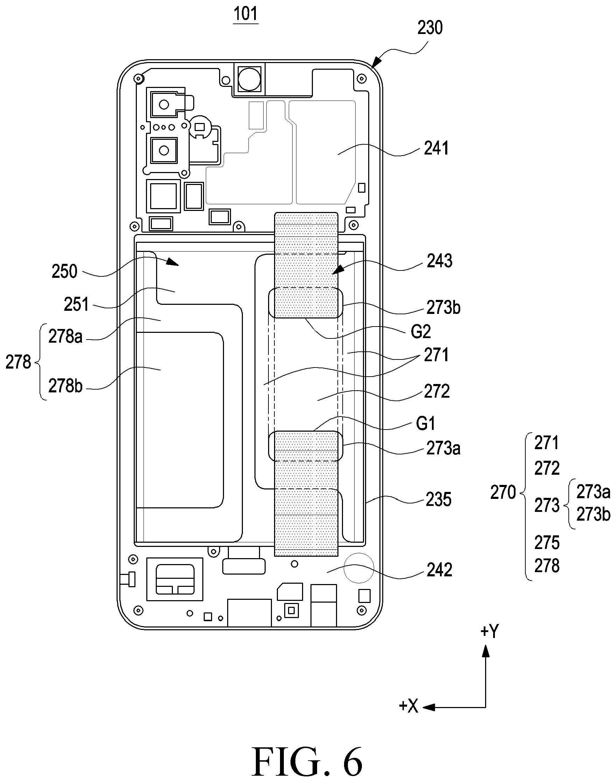

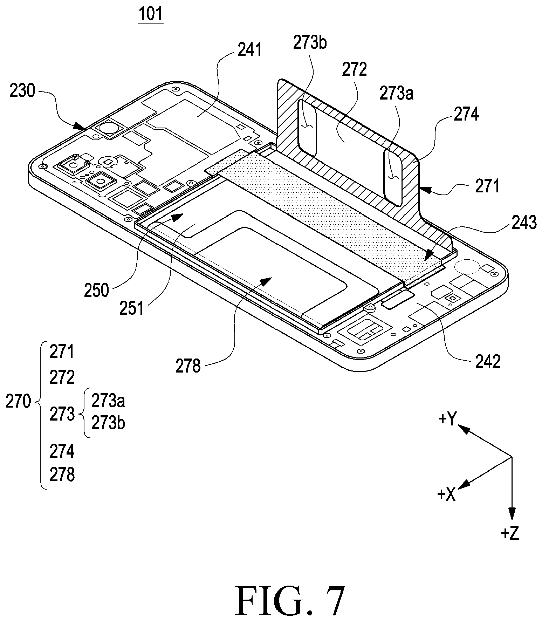

FIG. 6 is a rear view illustrating a battery 250, a flexible circuit board 243, and a fixing member 270 of an electronic device according to an embodiment of the disclosure. FIG. 7 is a perspective view illustrating a battery 250, a flexible circuit board 243, and a fixing member 270 of an electronic device 101 according to an embodiment of the disclosure.

In an embodiment, the housing 230 (e.g., the housing 210 of FIGS. 2 and 3 and/or the housing 230 of FIGS. 4 and 5) of the electronic device 101 may include a seating recess 235 in which at least a portion of the battery 250 (e.g., the battery 250 of FIGS. 4 and 5) is accommodated. For example, the seating recess 235 may be formed in one surface (e.g., the rear surface or the -Z direction surface) of the bracket or the first supporting member (e.g., the first supporting member 232 of FIGS. 4 and 5).

According to an embodiment, the flexible circuit board 243 (e.g., the flexible printed circuit board 240c of FIGS. 3 and 4) may be in the form of a strip extending in the length direction (e.g., the Y-axis direction). In an examples, the flexible circuit board 243, in the form of a strip, may extend further in a length direction (e.g., the Y-axis direction) (e.g. longer) than a width direction (e.g., the X-axis direction). In an embodiment, the flexible circuit board 243 may be connected to each of a plurality of circuit boards 241 and 242 to electrically connect the circuit boards 241 and 242 to each other. In an embodiment, the electronic device 101 may include a first circuit board 241 (e.g., the first circuit board 240a of FIGS. 4 and 5) disposed on one side (e.g., above or in the +Y direction) of the battery 250 and a second circuit board 242 (e.g., the second circuit board 240b of FIGS. 4 and 5) disposed on the other side (e.g., under or in the -Y direction) of the battery 250. According to an embodiment, the flexible circuit board 243 may be disposed between the first circuit board 241 (e.g., the first circuit board 240a of FIGS. 4 and 5) and the second circuit board 242 (e.g., the second circuit board 240b of FIGS. 4 and 5), and may electrically connect the two circuit boards 241 and 242. For example, the flexible circuit board 243 may be connected to the first circuit board 241 and/or the second circuit board 242 through connectors (not shown) provided at two opposite ends in the length direction (e.g., two opposite ends in the Y-axis direction).

In an embodiment, the electronic device 101 may include a fixing member 270 connected to at least a portion of the flexible circuit board 243. Referring to FIGS. 6 and 7, in an embodiment, the fixing member 270 may be disposed on one surface of the battery 250.

In the disclosure, the description focuses primarily on an example in which the fixing member 270 is coupled to the battery 250 that is disposed to overlap it, but the dispositional and coupling relationship between the fixing member 270 and the internal structure of the electronic device 101 are not limited thereto. The fixing member 270 may be disposed to overlap and/or coupled to another internal structure inside the electronic device 101, rather than the battery 250. In the disclosure, 'internal structure' may collectively refer to the bracket or first supporting member (e.g., the first supporting member 232 of FIGS. 4 and 5) of the housing 230 as well as an electronic components, e.g., a battery.

According to an embodiment, the battery 250 may include a seating surface (not shown) (e.g., a surface in the +Z direction) facing the seating recess 235, a coupling surface 251 (e.g., a surface in the -Z direction) facing the one surface and positioned adjacent to the flexible circuit board 243, and/or a side surface between the seating surface and the coupling surface 251.

In an embodiment, the fixing member 270 may include supporting areas 271 and 272 and/or an extension 278 respectively connected to the flexible circuit board 243 and the battery 250. In an embodiment, the flexible circuit board 243 may be disposed on the coupling surface 251. For example, the supporting areas 271 and 272 may be disposed in a partial area of the coupling surface 251 including an area where the coupling surface 251 and the flexible circuit board 243 overlap. For example, the flexible circuit board 243 may be disposed closer to the right side surface (e.g., a surface in the -X direction) of the battery 250 than the left side surface (e.g., a surface in the +X direction) of the battery 250. However, the position of the fixing member 270 is not limited thereto, but may be changed according to the dispositional relationship between the battery 250 and the flexible circuit board 243.

According to an embodiment, the extension 278 may overlap a portion of the coupling surface 251 of the battery 250. For example, the extension 278 may be disposed to surround at least a portion of the coupling surface 251 of the battery 250 from one side (e.g., +X direction). According to an embodiment, the extension 278 and the supporting areas 271 and 272 may be disposed on left and right side surfaces (e.g., side surfaces in the X direction), respectively, of the battery 250. That is, in an example, the extension 278 and the supporting areas 271 and 272 may be on different side surfaces of the battery 250. For example, the fixing member 270 may include a connection area (not shown) surrounding the seating surface of the battery 250. The connection area (not shown) may connect the supporting areas 271 and 272 and the extension 278.

In an embodiment, the extension 278 is a pull-tab member and may assist in removing the battery 250 from the seating recess 235. For example, the extension 278 may include a fixing portion 278a coupled to at least a portion of the battery 250 (e.g., a portion of the coupling surface 251) and a wing portion 278b connected to the fixing portion 278a. For example, at least a portion of the wing portion 278b may be disposed to overlap one surface (e.g., in the -Z direction) of the fixing portion 278a while being separated from the fixing portion 278a. For example, the battery 250 disposed in the seating recess 235 may be separated from the electronic device 101 by pulling the wing portion 278b. However, the shape, position and/or function of the extension 278 of the fixing member 270 is not limited thereto. For example, a portion (e.g., the wing portion) of the extension 278 may be omitted.

In an embodiment, some components of fixing member 270 (e.g., extension 278 and/or connection area (not shown)) may be omitted.

Referring to FIGS. 6 and 7, in an embodiment, the supporting areas 271 and 272 of fixing member 270 may include at least one through hole 273 through which the flexible circuit board 243 may pass through. In examples, each of at least one through hole 273 may form (or comprise) an opening between the fixing member 270 and a surface of the battery 250. For example, the supporting areas 271 and 272 may be thin film members. According to an embodiment, the supporting areas 271 and 272 may be disposed only on (e.g. may be positioned adjacent to) the coupling surface 251 of the battery 250 and may extend toward the seating surface (not shown) of the battery 250. According to an embodiment, the first supporting area 271 may form (e.g. may comprise) at least a portion of an edge of the supporting areas 271 and 272. For example, the first supporting area 271 may have a shape of a closed loop (e.g., a rectangular ring). According to an embodiment, a portion of the first supporting area 271 may extend in the length direction (e.g., the Y-axis direction) of the flexible circuit board 243 to provide stable coupling to the battery 250. Inan example, an extended portion of the first supporting area 271 may extend from the closed loop along a side surface of the battery 250 (e.g. along the Y-axis direction). For example, the first supporting area 271 may cover at least a portion of a side surface (e.g., a right side surface or a side surface in the -X direction) of the battery 250. According to an embodiment, the second supporting area 272 may be disposed inside the first supporting area 271. The shape of the supporting areas 271 and 272 is not limited, and for example, the shape of the supporting areas 271 and 272 may be irregular, polygonal, and/or a shape including a combination thereof. According to an embodiment, the through hole 273 may be formed between the first supporting area 271 and the second supporting area 272. That is, in an example, at least one through hole 273 may be formed wholly within the first supporting area 271, and at least partially within the second supporting area 272.

In an embodiment, a portion of the supporting areas 271 and 272 may not be coupled (or adhered) to the coupling surface 251. In an embodiment, the second supporting area 272 may not be coupled to the coupling surface 251 of the battery 250. The whole or a portion of the first supporting area 271 may be at least partially coupled (or adhered) to the coupling surface 251 of the battery 250.

Referring to FIG. 7, in an embodiment, an adhesive material 274 (e.g., an adhesive member, such as adhesive or tape) may be interposed between one surface of the first supporting area 271 and the coupling surface 251 of the battery 250 facing each other. For example, the adhesive material 274 may be provided on the whole or portion of one surface of the first supporting area 271. For example, a release film may be attached to the surface of the adhesive material 274 of the first supporting area 271. For example, the release film may be removed prior to use of the adhesive material 274. In an embodiment, the adhesive material 274 may not be disposed in the second supporting area 272. At least a portion of the second supporting area 272 may be disposed to face the coupling surface 251 of the battery 250 with the flexible circuit board 243 disposed therebetween. For example, the second supporting area 272 may support the flexible circuit board 243 in the thickness direction (e.g., + Z-axis direction) of the fixing member 270.

In an embodiment, the fixing member 270 may include a plurality of through holes 273. According to an embodiment, the plurality of through holes 273 include a first through hole 273a and a second through hole 273b spaced apart from each other in the length direction (e.g., the Y-axis direction) of the flexible circuit board 243. For example, the through hole 273 may be a hole or a slot penetrating in the thickness direction (e.g., the Z-axis direction) of the fixing member 270. The width (e.g., width in the X-axis direction) of the through hole 273 may be larger than or equal to the width (e.g., width in the X-axis direction) of the flexible circuit board 243. For example, the through hole 273 may have an elongated hole shape having a width (e.g., the width in the X-axis direction) larger than a length (e.g., the length in the Y-axis direction). In an embodiment, the first through hole 273a and/or the second through hole 273b may be formed between the first supporting area 271 and the second supporting area 272. For example, a portion of an edge of the first through hole 273a and/or the second through hole 273b may correspond to an edge of the first supporting area 271 or the second supporting area 272. According to an embodiment, in a state in which the fixing member 270 is coupled to the battery 250, a portion of an edge of the through hole 273 may be disposed adjacent to or brought into tight contact with the coupling surface 251 of the battery 250 while another portion may be spaced apart from the coupling surface 251. For example, the edge area of the through hole 273 formed in the first supporting area 271 may be brought in tight contact with the coupling surface 251 of the battery 250 through the adhesive material 274 provided on one surface of the first supporting area 271. For example, an edge area of the through hole 273 formed in the second supporting area 272 may be spaced apart from the coupling surface 251 of the battery 250 at a predetermined gap.

However, the position, number, and/or shape of the through holes 273 are not limited to those described above. For example, the position of the through hole may be changed depending on the position of the flexible circuit board 243. For example, one or more through holes 273 may be provided. For example, the through hole 273 may have a circular, elliptical, or polygonal shape, or a combination thereof or may have an irregular shape. In an embodiment, the through hole 273 may be omitted from the fixing member 270.

According to an embodiment, the battery 250, the flexible circuit board 243 and/or the fixing member 270 may be connected to each other in various manners. For example, referring to FIG. 7, prior to being connected to the flexible circuit board 243, the first supporting area 271 of the fixing member 270 may be provided without being coupled to the battery 250. For example, the right edge (e.g., in the -X direction) of the first supporting area 271 may be extended and fixed to the right side surface (e.g., the side surface in the -X direction) of the battery 250, and the remaining supporting areas 271 and 272 to be disposed on the coupling surface 251 may be provided in the state shown in FIG. 7. For example, for connection with the fixing member 270, the flexible circuit board 243 may have one end (e.g., end in the +Y direction) of two opposite ends in the length direction separated from the internal structure (e.g., the first circuit board 241) of the electronic device 101. The opposite end (e.g., the end in the -Y direction) of the flexible circuit board 243 may be fixed to or separated from the internal structure (e.g., the second circuit board 242) of the electronic device 101.

According to an embodiment, the one end (e.g., the end in the +Y direction) of the flexible circuit board 243 may be drawn in through the first through hole 273a in the direction from one surface (e.g., the surface in the -Z direction) of the fixing member 270 to the other surface (e.g., the surface in the +Z direction). The one end may be drawn out from the other surface (e.g., the surface in the +Z direction) of the fixing member 270 to the one surface (e.g., the surface in the -Z direction) through the second through hole 273b. The one end (e.g., the end in the +Y direction) of the flexible circuit board 243 passing through the second through hole 273b may be connected to the internal structure (e.g., the first circuit board 241) of the electronic device 101. For example, in a state where the flexible circuit board 243 passes through the through hole 273, the first supporting area 271 may be coupled (or adhered) to the coupling surface 251 of the battery 250. A portion between two opposite ends of the flexible circuit board 243 in the length direction (e.g., two opposite ends in the Y-axis direction) may be disposed between the second supporting area and the coupling surface 251 of the battery 250. For example, in a state in which the fixing member 270 is connected to the flexible circuit board 243 and the battery 250, the through hole 273 of the fixing member 270 may permit a displacement in the length direction (e.g., the Y-axis direction) of the flexible circuit board 243. For example, in a state in which the fixing member 270 is connected to the flexible circuit board 243 and the battery 250, the second supporting member may limit the displacement in the thickness direction (e.g., the Z-axis direction) of the flexible circuit board 243.

The above description of the connection between the battery 250, the flexible circuit board 243, and/or the fixed member 270 is merely an example, and the disclosure is not intended thereto. For example, for connection with the fixing member 270, as opposed thereto, the flexible circuit board 243 may have one end (e.g., end in the -Y direction) of two opposite ends in the length direction separated from the internal structure (e.g., the second circuit board 242) of the electronic device 101. The opposite end (e.g., the end in the +Y direction) of the flexible circuit board 243 may be fixed to or separated from the internal structure (e.g., the first circuit board 241) of the electronic device 101. For example, the one end (e.g., the end in the -Y direction) of the flexible circuit board 243 may be drawn in through the second through hole 273b in the direction from one surface (e.g., the surface in the -Z direction) of the fixing member 270 to the other surface (e.g., the surface in the +Z direction). The one end (e.g., the end in the -Y direction) may be drawn out from the other surface (e.g., the surface in the +Z direction) of the fixing member 270 to the one surface (e.g., the surface in the -Z direction) through the second through hole 273b.

In an embodiment, the second supporting area 272 may permit displacement of the flexible circuit board 243 in the length direction (e.g., the Y-axis direction) while limiting displacement in some directions (e.g., the Z-axis direction and/or the X-axis direction). According to an embodiment, in a state in which the fixing member 270 is coupled to the battery 250, the second supporting area 272 may be shaped such that the flexible circuit board 243 in one direction (e.g., the Y-axis direction) while surrounding at least a portion of the flexible circuit board 243.

For example, in a state in which the fixing member 270 is coupled to the battery 250, a portion (e.g., an edge in the X direction) of the second supporting area 272 extending from the first supporting area 271 may be closed by the first supporting area 271. For example, in a state in which the fixing member 270 is coupled to the battery 250, a portion (e.g., an edge in the Y-axis direction) of the second supporting area 272 corresponding to a portion of an edge of the through hole 273 may form openings G1 and G2 (e.g., openings G1 and G2 of FIG. 6) between it and its facing coupling surface 251. For example, the second supporting area 272 may form a pair of openings G1 and G2 corresponding to a pair of through holes 273 in a state in which the fixing member 270 is coupled to the battery 250. For example, the fixing member 270 may include a first opening G1 positioned at the lower end (e.g., the end in the -Y-axis direction) of the second supporting area 272 and a second opening G2 positioned at the upper end (e.g., the end in the +Y-axis direction). For example, the openings G1 and G2 and/or the through hole 273 may permit displacement of the flexible circuit board 243 in the Y-axis direction.

According to an embodiment, the second supporting area 272 may be spaced apart from the coupling surface 251 by a designated gap. For example, the designated gap may be set to allow passage of the flexible circuit board 243 into a space between the second supporting area 272 and the battery 250.

In some examples, the portion of the flexible circuit board may be accommodated in a passage (or space) formed between the second supporting area and the surface of the internal structure or battery 250 (e.g. the coupling surface 251 thereof). That is, the passage may be formed by the designated gap (or space) between the battery 250 and the second supporting area 272 (e.g. an upper side or roof of the passage is formed by the second supporting area, and a lower side or floor of the passage is formed by a surface of the battery 250), and a size of the designated gap may define a height of the passage. Herein, passage may alternatively defined as a guide, or tunnel, as formed between the internal structure and the second supporting area 272. In some examples, the passage is formed (or bounded) between at least one opening (e.g. openings G1 and G2). Whilst the above-detailed description of the passage is made here, it will be appreciated that the passage as described may also be formed with respect to the examples referred to throughout the detailed description.

The designated gap may be a minimum gap at which displacement of the flexible circuit board 243 in the length direction (e.g., the Y-axis direction) is possible. For example, the designated gap may be larger than or equal to the thickness (e.g., the thickness in the Z-axis direction) of the flexible circuit board 243. According to an embodiment, the second supporting area 272 may limit the displacement of the flexible circuit board in the thickness direction (e.g., the Z-axis direction) to the designated gap or less. However, the shape and/or number of the second supporting areas 272 is not limited thereto.

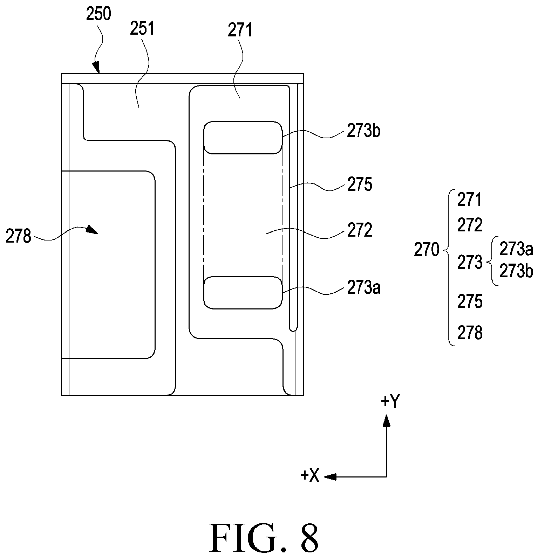

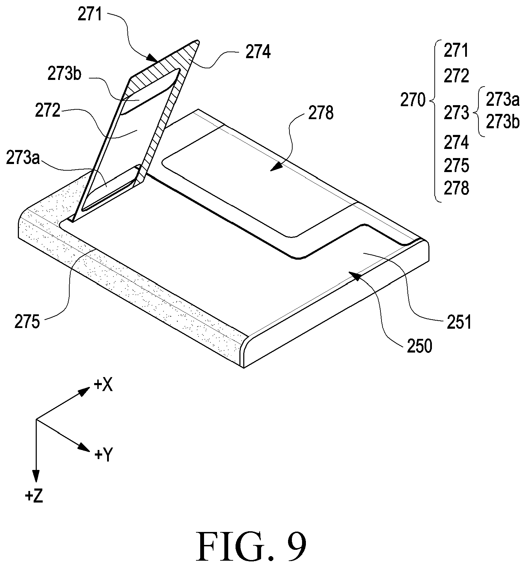

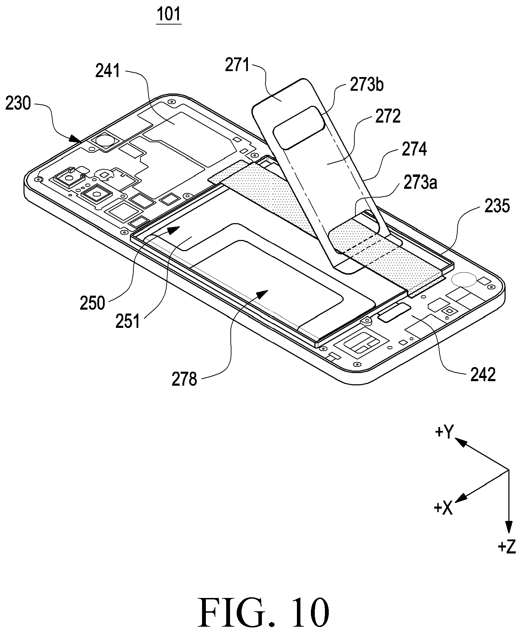

FIG. 8 is a plan view illustrating a fixing member 270 according to an embodiment of the disclosure. FIG. 9 is a perspective view illustrating a fixing member 270 according to an embodiment of the disclosure. FIG. 10 is a perspective view illustrating a battery 250, a flexible circuit board 243, and a fixing member 270 of an electronic device 101 according to an embodiment of the disclosure.

The electronic device 101 of FIG. 10 may be referred to as the electronic device 101 of FIGS. 6 and 7. The battery 250 of FIGS. 8 to 10 may be referred to as the battery 250 of FIGS. 6 and 7. The configuration of the fixing member 270 of FIGS. 8 to 10 may be identical in whole or part to the configuration of the fixing member 270 of FIGS. 6 and 7, and the above description may likewise apply to the fixing member 270 of FIGS. 8 to 10.

The fixing member 270 of FIGS. 8 to 10 may be at least partially different from the fixing member 270 of FIGS. 6 and 7 in some configurations of the first supporting area 271. As the fixing member 270 of FIGS. 8 to 10 further includes a cutting area 275, the method for attaching the fixing member to the internal structure (e.g., battery 250) of the electronic device 101 may at least partially differ from that of the fixing member 270 of FIGS. 6 and 7. In the following description, the whole or part of the duplicate description of the electronic device 101, the battery 250, the flexible circuit board 243, and the fixing member 270 may be omitted. The following description focuses primarily on the differences of the fixing member 270 of FIGS. 8 and 10 from the fixing member 270 of FIGS. 6 and 7.

Referring to FIG. 8, in an embodiment, the fixing member 270 may include at least one cutting area 275 formed in the first supporting area 271. For example, the cutting area 275 may be a slit produced by removing a portion of the fixing member 270. The cutting area 275 may be a slit extending in the length direction (e.g., the Y-axis direction) of the flexible circuit board 243 between two opposite ends. In an embodiment, the cutting area 275 may extend from the open end in the length direction (e.g., the Y-axis direction) of the flexible circuit board 243. For example, the open end may be formed at an upper edge (e.g., the edge in the +Y-direction) of the fixing member 270. For example, the end opposite to the open end may be a closed end adjacent to the lower edge (e.g., the edge in the -Y direction).

In an embodiment, the cutting area 275 may be provided on one side (e.g., the side in the -X direction) of the first through hole 273a and the second through hole 273b. Referring to FIGS. 9 and 10, e.g., a left portion (e.g., a portion in the +X direction) where the first through hole 273a and the second through hole 273b are formed in the first supporting area 271 with the cutting area 275 as a boundary may be lifted from the battery 250. For example, a right portion (e.g., a portion in the -X direction) of the first supporting area 271 with the cutting area 275 as a boundary may be fixed to the battery 250. Referring to FIGS. 9 and 10, e.g., a guide line may be formed below the first through hole 273a to help the left portion of the first supporting area 271 be bent. For example, the guide line may be a groove extending in a direction (e.g., the X-axis direction) crossing the length direction of the flexible circuit board 243. The shape, number, and position of the left partial cutting areas 275 of the first supporting area 271 are not limited. For example, a pair of cutting areas 275 may be placed on the left side (e.g., the side in the +X direction) and right side (e.g., the side in -X direction) of the through hole 273.

Referring to FIG. 9, in an embodiment, a portion of the first supporting area 271 may be coupled (or adhered) to the coupling surface 251, and another portion may not be coupled to the coupling surface 251. The second supporting area 272 may not be coupled to the coupling surface 251 of the battery 250. In an embodiment, an adhesive material 274 (e.g., an adhesive member, such as adhesive or tape) may be interposed between a portion of one surface of the first supporting area 271 and the coupling surface 251 of the battery 250 facing each other. For example, the adhesive material 274 may be provided on a portion of one surface of the first supporting area 271. According to an embodiment, the first supporting area 271 may include a non-adhesive area between the cutting area 275 and the second supporting area 272 where the adhesive material 274 is not provided. For example, the non-adhesive area may be formed along the whole or portion of the cutting area 275. However, the above description is merely an example, and the adhesive material 274 may be disposed on the entire surface of the first supporting area 271 facing the battery 250. According to an embodiment, the second supporting area 272, the flexible circuit board 243, and/or the battery 250 may not be coupled (or adhered) to each other in an overlapping area.

According to an embodiment, the battery 250, the flexible circuit board 243 and/or the fixing member 270 may be connected to each other in various manners. Referring to FIGS. 9 and 10, for connection with the flexible member (e.g. flexible circuit board 243), only a portion of the first supporting member of the fixing member 270 may be adhered to the coupling surface 251 of the battery 250. For example, the left portion (e.g., in the +X direction) of the first supporting member with the cutting area 275 as a boundary may be lifted. For example, the right portion (e.g., the portion in the -X direction) with the cutting area 275 as a boundary may be coupled to the battery 250 before and after passing the flexible circuit board 243 through the pair of through holes 273 of the fixing member 270. For example, the right edge (e.g., in the -X direction) of the first supporting area 271 may be extended and fixed to the right side surface (e.g., in the -X direction) of the battery 250. For example, for connection with the fixing member 270, the flexible circuit board 243 may be provided so that one end (e.g., the end in the +Y direction) of two opposite ends in the length direction thereof is separated from the internal structure (e.g., the first circuit board 241), and the opposite end (e.g., the end in the -Y direction) is fixed to the internal structure (e.g., the second circuit board 242).

According to an embodiment, the one end (e.g., the end in the +Y direction) of the flexible circuit board 243 may be drawn in through the first through hole 273a in the direction from one surface (e.g., the surface in the -Z direction) of the fixing member 270 to the other surface (e.g., the surface in the +Z direction). The one end may be drawn out from the other surface (e.g., the surface in the +Z direction) of the fixing member 270 to the one surface (e.g., the surface in the -Z direction) through the second through hole 273b. The one end (e.g., the end in the +Y direction) of the flexible circuit board 243 passing through the second through hole 273b may be connected to the internal structure (e.g., the first circuit board 241) of the electronic device 101. The left portion (e.g., the portion in the +X direction) of the first supporting area 271 lifted from the battery 250 with the cutting area 275 as a boundary may be coupled (or adhered) to the coupling surface 251 of the battery 250. For example, in a state in which the fixing member 270 is connected to the flexible circuit board 243 and the battery 250, a portion between two opposite ends of the flexible circuit board 243 in the length direction (e.g., ends in the Y-axis direction) may be disposed between the second supporting area and the coupling surface 251 of the battery 250. For example, in a state in which the fixing member 270 is connected to the flexible circuit board 243 and the battery 250, the through hole 273 of the fixing member 270 may permit a displacement in the length direction (e.g., the Y-axis direction) of the flexible circuit board 243. For example, in a state in which the fixing member 270 is connected to the flexible circuit board 243 and the battery 250, the second supporting member may limit the displacement in the thickness direction (e.g., the Z-axis direction) of the flexible circuit board 243.

The above description of the connection between the battery 250, the flexible circuit board 243, and/or the fixed member 270 is merely an example, and the disclosure is not intended thereto. For example, for connection with the fixing member 270, as opposed thereto, the flexible circuit board 243 may have one end (e.g., end in the -Y direction) of two opposite ends in the length direction separated from the internal structure (e.g., the second circuit board 242) of the electronic device 101. For example, the one end (e.g., the end in the -Y direction) of the flexible circuit board 243 may be drawn in through the second through hole 273b in the direction from one surface (e.g., the surface in the -Z direction) of the fixing member 270 to the other surface (e.g., the surface in the +Z direction). The one end (e.g., the end in the -Y direction) may be drawn out from the other surface (e.g., the surface in the +Z direction) of the fixing member 270 to the one surface (e.g., the surface in the -Z direction) through the second through hole 273b.

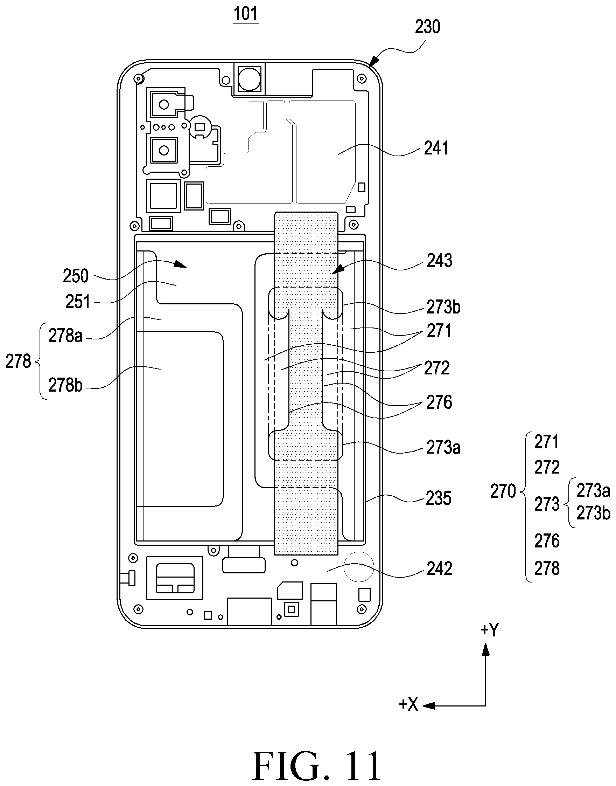

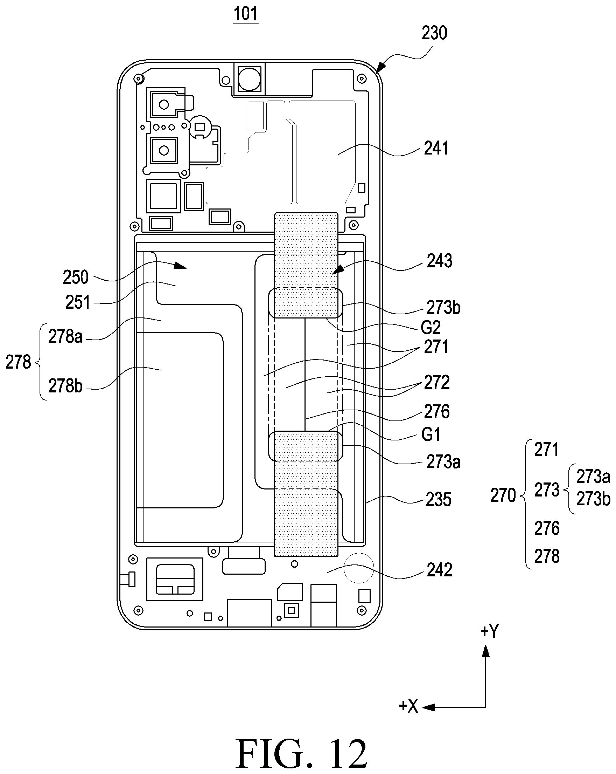

FIGS. 11 and 12 are rear views illustrating a battery 250, a flexible circuit board 243, and a fixing member 270 of an electronic device according to an embodiment of the disclosure.

The electronic device 101 of FIGS. 11 and 12 may be referred to as the electronic device 101 of FIG. 10. The battery 250 of FIGS. 11 and 12 may be referred to as the battery 250 of FIGS. 8 to 10. The configuration of the fixing member 270 of FIGS. 11 and 12 may be identical in whole or part to the configuration of the fixing member 270 of FIGS. 6 and 7 and/or the fixing member 270 of FIGS. 8 to 10, and the above description may likewise apply to the fixing member 270 of FIGS. 11 and 12.

The configuration of the fixing member 270 of FIGS. 11 and 12 may be at least partially different from the configuration of the fixing member 270 of FIGS. 6 and 7 and/or the fixing member 270 of FIGS. 8 to 10. As the fixing member 270 of FIGS. 11 and 12 includes a cutout 276 in the second supporting area 272, the method for attaching the fixing member 270 to the internal structure (e.g., the battery 250) of the electronic device 101 may at least partially differ from that for the fixing member 270 of FIGS. 6 and 7 and/or the fixing member 270 of FIGS. 8 to 10. In the following description, the duplicate description of the electronic device 101, the battery 250, the flexible circuit board 243, and the fixing member 270 may be omitted. The following description focuses primarily on the differences of the fixing member 270 of FIGS. 11 and 12 from the above-described fixing members 270.

Referring to FIGS. 11 and 12, in an embodiment, the second supporting area 272 may include a cutout 276 formed between upper and lower edges (e.g., the edges in the Y-axis direction). For example, the cutout 276 may extend in the length direction of the flexible circuit board 243. For example, the second supporting area 272 may be divided into a left portion (e.g., in the +X direction) and a right portion (e.g., in the -X direction) by the cutout 276. For example, at least a portion of the fixing member 270 including the second supporting area 272 may include an elastically deformable material. According to an embodiment, the second supporting area 272 may be open by the cutout 276. For example, a gap into which the flexible circuit board 243 may be inserted may be formed between the left portion (e.g., in the +X direction) and right portion (e.g., in the -X direction) of the second supporting area 272. However, the shape and position of the cutout 276 is not limited to those described above. For example, the cutout 276 may be formed along the left edge (e.g., in the +Z direction) or right edge (e.g., in the -X direction) of the second supporting area 272 connected to the first supporting area 271.

According to an embodiment, the battery 250, the flexible circuit board 243 and/or the fixing member 270 may be connected to each other in various manners. For example, for connection with the fixing member 270, the flexible circuit board 243 may have one end (e.g., the end in the Y-axis direction) of two opposite ends in the length direction separated from the internal structure (e.g., the first circuit board 241 or the second circuit board 242) of the electronic device 101. In a state in which one end of the flexible circuit board 243 is separated, the fixing member 270 may be coupled (or adhered) to the battery 250. For example, the fixing member 270 may be attached to the coupling surface 251 of the battery 250 through an adhesive material 274 (e.g., the adhesive material 274 of FIGS. 7 and/or 9) provided on one surface of the first supporting area 271. For example, referring to FIG. 11, in a state in which the first supporting area 271 is fixed to the battery 250, the second supporting area 272 may be open by the cutout 276, and the flexible circuit board 243 may be inserted into the open gap of the second supporting area 272. For example, referring to FIG. 12, a portion of the flexible circuit board 243 may be disposed between the second supporting area 272 and the coupling surface 251 of the battery 250. it may be extended and fixed (e.g., in the -X direction). For example, in a state in which the fixing member 270 is connected to the flexible circuit board 243 and the battery 250, the through hole 273 of the fixing member 270 may permit a displacement in the length direction (e.g., the Y-axis direction) of the flexible circuit board 243. For example, in a state in which the fixing member 270 is connected to the flexible circuit board 243 and the battery 250, the second supporting member may limit the displacement in the thickness direction (e.g., the Z-axis direction) of the flexible circuit board 243. The above description of the connection between the battery 250, the flexible circuit board 243, and/or the fixed member 270 is merely an example, and the disclosure is not intended thereto. For example, a method in which the flexible circuit board 243 is drawn in and/or out through the first through hole 273a and/or the second through hole 273b to be connected to the fixing member 270 may be used.

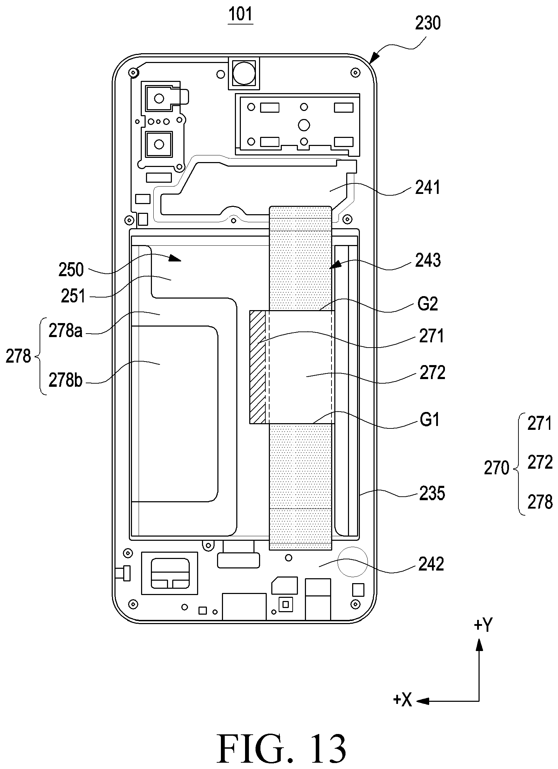

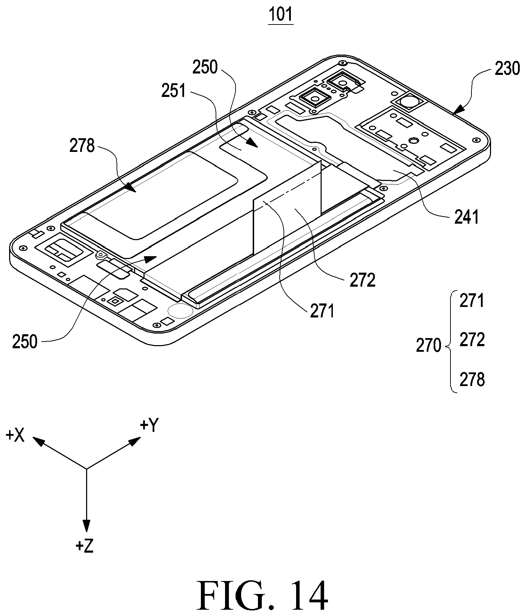

FIG. 13 is a rear view illustrating a battery 250, a flexible circuit board 243, and a fixing member 270 of an electronic device according to an embodiment of the disclosure. FIG. 14 is a perspective view illustrating a battery 250, a flexible circuit board 243, and a fixing member 270 of an electronic device 101 according to an embodiment of the disclosure.

The electronic device 101 of FIGS. 13 and 14 may be referred to as the electronic device 101 of FIGS. 11 and 12. The battery 250 of FIGS. 13 and 14 may be referred to as the battery 250 of FIGS. 11 and 12. The configuration of the fixing member 270 of FIGS. 13 and 14 may be identical in whole or part to the configuration of the fixing member 270 of FIGS. 6 and 7, the fixing member 270 of FIGS. 8 to 10, and/or the fixing member 270 of FIGS. 11 and 12, and the above description may likewise apply to the fixing member 270 of FIGS. 13 and 14.

The configuration of the fixing member 270 of FIGS. 13 and 14 may be at least partially different from the configuration of the fixing member 270 of FIGS. 6 and 7, the fixing member 270 of FIGS. 8 to 10, and/or the fixing member 270 of FIGS. 11 and 12. As the fixing member 270 of FIGS. 13 and 14 omits the through hole 273, the method for attaching the fixing member 270 to the internal structure (e.g., the battery 250) of the electronic device 101 may at least partially differ from that for the fixing member 270 of FIGS. 6 and 7, the fixing member 270 of FIGS. 8 to 10, and/or the fixing member 270 of FIGS. 11 and 12. In the following description, the duplicate description of the electronic device 101, the battery 250, the flexible circuit board 243, and the fixing member 270 may be omitted. The following description focuses primarily on the differences of the fixing member 270 of FIGS. 13 and 14 from the above-described fixing members 270.

Referring to FIGS. 13 and 14, in an embodiment, the supporting areas 271 and 272 may include a first supporting area 271 and a second supporting area 272. An adhesive member may be provided at least partially on one surface of the first supporting area 271 facing the coupling surface 251 of the battery 250. For example, the first supporting area 271 may form left (e.g., in the +X direction) and right (e.g., in the -X direction) edges of the supporting areas 271 and 272 disposed on the coupling surface 251. For example, the right edge of the first supporting area 271 may extend to the side surface (e.g., the right side surface or the side surface in the -X direction) of the battery 250. According to an embodiment, the second supporting area 272 may be disposed between two portions of the first supporting area 271. For example, the width (e.g., the width in the X-axis direction) of the second supporting area 272 may be larger than or equal to the width (e.g., the width in the X-axis direction) of the flexible circuit board 243. In an embodiment, portions overlapping the first supporting area 271 and the coupling surface 251 of the battery 250 may be coupled to each other, and portions overlapping the second supporting area 272 and the coupling surface 251 of the battery 250 may be spaced apart from each other at a predetermined interval.

According to an embodiment, two opposite ends of the second supporting area 272 (e.g., the ends in the Y-axis direction) may form openings G1 and G2 between them and the coupling surface 251 with the fixing member 270 attached to the coupling surface 251 of the battery 250 through the first supporting area 271. For example, the fixing member 270 may include a first opening G1 positioned at the lower end (e.g., the end in the -Y-axis direction) of the second supporting area 272 and a second opening G2 positioned at the upper end (e.g., the end in the +Y-axis direction). For example, in a state in which the fixing member 270 is attached to the battery 250, the pair of openings G1 and G2 may permit displacement of the flexible circuit board 243 in the length direction (e.g., the Y-axis direction).

According to an embodiment, the battery 250, the flexible circuit board 243 and/or the fixing member 270 may be connected to each other in various manners. For example, referring to FIG. 14, the fixing member 270 may be coupled to the battery 250 in a state in which a portion (e.g., the end in the Y-axis direction) of the flexible circuit board 243 is fixed to the internal structure (e.g., the first circuit board 241 or the second circuit board 242) of the electronic device 101. For example, a portion (e.g., the edge in the +X direction) of the first supporting area 271 may be coupled to the battery 250 so that the second supporting area 272 covers a portion of the flexible circuit board 243. For example, another portion (e.g., the portion in the -X direction) of the first supporting area 271 may be coupled to one surface of the battery 250 before or after fixing of the flexible circuit board 243 is complete. The above description of the connection between the battery 250, the flexible circuit board 243, and/or the fixed member 270 is merely an example, and the disclosure is not intended thereto. For example, the flexible circuit board 243 may be fixed to the internal structure of the electronic device 101 after a portion (e.g., the edge in the +X direction) of the first supporting area 271 is adhered to the coupling surface 251. For example, a method in which the flexible circuit board 243 is drawn in and/or out through the first through hole 273a and/or the second through hole 273b to be connected to the fixing member 270 may be used.

The embodiments regarding the fixing member 270 of FIGS. 6 and 7, the fixing member 270 of FIGS. 8 to 10, and/or the fixing member 270 of FIGS. 11 and 12 disclosed herein are not mutually exclusive, but rather some or all thereof may be combined. For example, the embodiment described with reference to FIGS. 8 to 10 and the embodiment described with reference to FIGS. 11 and 12 may be combined.

Typically, the interior of an electronic device may include a battery and a flexible circuit board that electrically connects printed circuit boards disposed above and under the battery. For example, the flexible circuit board may be connected to the printed circuit board through connectors disposed at two opposite ends in the length direction. Typically, the flexible circuit board may be in the form of a strip and may be disposed across one side of the battery. For example, if the electronic device is subjected to an external impact by being deformed or dropped, the flexible circuit board may be displaced in the length direction thereof. Therefore, when the flexible circuit board is placed in tight contact with the battery without a length margin, the connector may be pulled together with the flexible circuit board and damaged when the flexible circuit board is displaced in the length direction. On the other hand, giving a margin to the length of the flexible circuit board may inhibit damage due to flow, but may cause lift from one side of the battery. For example, the lifting of the flexible circuit board may be visually recognized through the rear surface of the electronic device. Therefore, it is necessary to fix the flexible circuit board to the battery or an electric or electronic component or an internal structure (hereinafter referred to as 'internal structure') to secure the flexibility of the flexible circuit board in the length direction while suppressing lift.

Typically, the flexible circuit board may be fixed to the battery by an adhesive material, such as double-sided tape. However, when the double-sided tape is used, if an external impact is applied to the electronic device (e.g., a fall), the adhesion of the double-sided tape may be deteriorated or released. Further, when the double-sided tape is released, the attachment surface of the flexible circuit board may be torn off and damaged.

Embodiments of the disclosure relate to a fixing member for connecting a flexible circuit board to an internal structure (e.g., a battery) of an electronic device in a non-adhesive way and aims to provide a fixing member that limits the displacement of the flexible circuit board in the thickness direction, and an electronic device including the same.

The fixing member according to an embodiment of the disclosure may prevent or reduce damage to the connector or flexible circuit board that may occur when the flexible circuit board is displaced in the length direction due to, e.g., external impact in a case where displacement of the flexible circuit board in the length direction is allowed so that the flexible circuit board is completely fixed to the internal structure.

The fixing member according to an embodiment of the disclosure may limit displacement of the flexible circuit board in the electronic device in the thickness direction, thus suppressing lift of the flexible circuit board and its resultant poor appearance of the electronic device.

According to an embodiment of the disclosure, the flexible circuit board may be connected to an internal structure of the electronic device through the fixing member, and no adhesive material is applied to the flexible circuit board, so that it is possible to suppress damage to the flexible circuit board, such as tearing.

According to an embodiment of the disclosure, an electronic device (101 of FIGS. 1 to 7 and 9 to 14) may comprise a housing (210 of FIGS. 2 and 3; 230 of FIGS. 4 to 6, 7, and 10 to 14), an internal structure (e.g., 250 of FIGS. 4 to 14) disposed in the housing, a flexible circuit board (230c of FIGS. 4 and 5; 243 of FIGS. 6, 7, and 10 to 14) disposed to cross one surface (e.g., 251 of FIGS. 6 to 14) of the internal structure in a first direction, and/or a fixing member (270 of FIGS. 6 to 14). The fixing member may include a first supporting area (271 of FIGS. 6 to 14) coupled to the one surface of the internal structure and a second supporting area (272 of FIGS. 6 to 14) extending from the first supporting area. The second supporting area may include at least one opening (G1 and G2 of FIGS. 6, 12, and 13) formed in a partial area to allow the flexible circuit board to pass through. A portion of the flexible circuit board may be disposed between the internal structure and the second supporting area

In an embodiment, the flexible circuit board may be displaceable in the first direction through the at least one opening of the second supporting area.

In an embodiment, an adhesive material (e.g., 274 of FIGS. 7 and 9) may be disposed between at least a portion of the first supporting area and the one surface of the internal structure.

In an embodiment, the flexible circuit board may be displaced in the first direction through the at least one opening of the second supporting area.

In an embodiment, the at least one opening of the second supporting area may comprise a pair of openings (G1, G2) spaced apart from each other in the first direction.

In an embodiment, a passage accommodating a portion of the flexible circuit board may be formed between the second supporting area and the one surface of the internal structure. The pair of openings may be formed at two opposite ends of the passage in the first direction.

In an embodiment, a portion of the first supporting area may be connected to an edge of the second supporting area in a second direction (e.g., the X-axis direction) crossing the first direction and coupled to the one surface of the internal structure (e.g., see FIGS. 13 and 14).

In an embodiment, the second supporting area may be spaced apart from the one surface of the internal structure by a designated distance.

In an embodiment, the designated distance may be equal to or larger than a thickness of the flexible circuit board.

In an embodiment, the first supporting area may be formed in a shape surrounding at least a portion of an edge of the second supporting area (e.g., see FIGS. 6 to 12).

In an embodiment, the fixing member may further include at least one through hole (e.g., 273 of FIGS. 6-12) formed between the first supporting area and the second supporting area. The at least one opening of the second supporting area may be formed between a portion of the through hole and the one surface of the internal structure.

In an embodiment, the fixing member includes a pair of through holes (e.g., 273a and 273b of FIGS. 6 to 12) spaced apart in the first direction, and the second supporting area may be disposed between the pair of through holes.

In an embodiment, the fixing member further includes a cutout (e.g., 276 of FIGS. 11 to 12) formed in the second supporting area. The cutout is formed in a shape of cutting between the pair of through holes in at least one direction.

In an embodiment, the fixing member may further include a cutting area (e.g., 275 of FIGS. 8 to 10) in a shape of removing of a portion of the first supporting area has been removed. The cutting area may be formed extending in the first direction in an area adjacent to an edge of the first support area

In an embodiment, the internal structure may include a battery.

According to an embodiment of the disclosure, an electronic device may comprise a housing (210 of FIGS. 2 and 3;230 of FIGS. 4 to 6, 7, and 10 to 14) including a seating recess 235, a battery 250 disposed in the seating recess, a flexible circuit board (230c of FIGS. 4 and 5; 243 of FIGS. 6, 7, and 10 to 14) disposed to cross one surface 251 of the battery, and a fixing member. The fixing member may include a first supporting area coupled to the one surface of the battery and a second supporting area extending from the first supporting area. The second supporting area may include at least one opening (G1 and G2 of FIGS. 6, 12, and 13) formed in a partial area to allow the flexible circuit board to pass through. A portion of the flexible circuit board may be disposed between the battery and the second supporting area.

In an embodiment, the battery, the flexible circuit board, and the second supporting area may not be coupled to each other in an area where they overlap each other.

In an embodiment, an adhesive material (e.g., 274 of FIGS. 7 and 9) may be disposed between at least a portion of the first supporting area and the one surface of the battery.

In an embodiment, the flexible circuit board may be displaced in a direction (e.g., the Y-axis direction) where the flexible circuit board crosses the one surface through the at least one opening of the second supporting area.

In an embodiment, the second supporting area may be spaced apart from the one surface of the battery by a designated distance. The designated distance may be equal to or larger than a thickness of the flexible circuit board.

According to an embodiment of the disclosure, an electronic device may comprise a housing (210; 230), an internal structure disposed in the housing (210; 230), a fixing member (270) including a first supporting area (271) coupled to one surface of the internal structure and a second supporting area (272) extending from the first supporting area and/or a flexible circuit board (230c; 243) disposed to cross the one surface (251) of the internal structure in a first direction. A portion of the flexible circuit board may pass through a passage formed between the second supporting area and the one surface of the internal structure.

In an embodiment, the internal structure, the flexible circuit board, and the second supporting area may be arranged so as to not couple to each other in an area where they overlap each other.

In an embodiment, an adhesive material (274) may be disposed between at least a portion of the first supporting area (271) and the one surface (251) of the internal structure.

In an embodiment, the second supporting area (272) may comprise at least one opening (G1, G2) through which the flexible circuit board passes through; and the flexible circuit board may be displaceable in the first direction through the at least one opening of the second supporting area.

In an embodiment, the at least one opening of the second supporting area may comprise a pair of openings (G1, G2) spaced apart from each other in the first direction.

In an embodiment, the pair of openings may be formed at two opposite ends of the passage in the first direction.

In an embodiment, a portion of the first supporting area may be connected to an edge of the second supporting area in a second direction crossing the first direction and coupled to the one surface of the internal structure.

In an embodiment, the at least one opening may be formed between a portion of the second supporting area and the one surface of the internal structure.

In an embodiment, the at least one opening may include a pair of through holes (273a, 273b), spaced apart in the first direction, and wherein the second supporting area is disposed between the pair of through holes.

In an embodiment, the fixing member may further include a cutout (276) formed in the second supporting area, and the cutout may be formed between the pair of through holes (273a, 273b) in at least one direction.

In an embodiment, the fixing member may further include a cutting area (275) in a portion of the first supporting area, and the cutting area may be formed extending in the first direction in an area adjacent to an edge of the first supporting area.

In an embodiment, the second supporting area may be spaced apart from the one surface (251) of the internal structure by a predetermined distance to define a height of the passage; and the predetermined distance may be larger than or equal to a thickness of the flexible circuit board.

In an embodiment, the first supporting area may be formed to surround at least a portion of an edge of the second supporting area.

In an embodiment, the internal structure may include a battery.

In an embodiment, the housing (210; 230) may comprise a seating recess (235); and the battery (250) may be disposed in the seating recess.

The electronic device according to an embodiment of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

An embodiment of the disclosure and terms used therein are not intended to limit the technical features described in the disclosure to specific embodiments, and should be understood to include various modifications, equivalents, or substitutes of the embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1^{st}" and "2^{nd}," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in the form of an application-specific integrated circuit (ASIC).

An embodiment of the disclosure may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a compiler or a code executable by an interpreter. The storage medium readable by the machine may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to an embodiment of the disclosure may be included and provided in a computer program product. The computer program products may be traded as commodities between sellers and buyers. The computer program product may be distributed in the form of a machine-readable storage medium (e.g., compact disc read only memory (CD-ROM)), or be distributed (e.g., downloaded or uploaded) online via an application store (e.g., Play Store^{™}), or between two user devices (e.g., smartphones) directly. If distributed online, at least part of the computer program product may be temporarily generated or at least temporarily stored in the machine-readable storage medium, such as memory of the manufacturer's server, a server of the application store, or a relay server.

According to an embodiment, each component (e.g., a module or a program) of the above-described components may include a single entity or multiple entities. Some of the plurality of entities may be separately disposed in different components. According to an embodiment, one or more of the above-described components may be omitted, or one or more other components may be added. Alternatively or Further, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to an embodiment, operations performed by the module, the program, or another component may be carried out sequentially, in parallel, repeatedly, or heuristically, or one or more of the operations may be executed in a different order or omitted, or one or more other operations may be added.

## Claims

1. An electronic device (101) comprising:
a housing (210; 230);
an internal structure disposed in the housing ;
a fixing member (270) including a first supporting area (271) coupled to one surface (251) of the internal structure and a second supporting area (272) extending from the first supporting area,
a flexible circuit board (230c; 243) disposed to cross the one surface (251) of the internal structure in a first direction; and
wherein a portion of the flexible circuit board passes through a passage formed between the second supporting area and the one surface of the internal structure.

2. The electronic device of claim 1, wherein the internal structure, the flexible circuit board, and the second supporting area are arranged so as to not couple to each other in an area where they overlap each other.

3. The electronic device of claim 1 or 2, wherein an adhesive material (274) is disposed between at least a portion of the first supporting area (271) and the one surface (251) of the internal structure.

4. The electronic device of any of claims 1 to 3, wherein the second supporting area (272) comprises at least one opening (G1, G2) through which the flexible circuit board passes through; and
wherein the flexible circuit board is displaceable in the first direction through the at least one opening of the second supporting area.

5. The electronic device of claim 4, wherein the at least one opening of the second supporting area comprises a pair of openings (G1, G2) spaced apart from each other in the first direction.

6. The electronic device of claim 5, wherein the pair of openings are formed at two opposite ends of the passage in the first direction.

7. The electronic device of claim 6, wherein a portion of the first supporting area is connected to an edge of the second supporting area in a second direction crossing the first direction and coupled to the one surface of the internal structure.

8. The electronic device of claim 4 to 7, wherein the at least one opening is formed between a portion of the second supporting area and the one surface of the internal structure.

9. The electronic device of claims 1 to 8, wherein the at least one opening includes a pair of through holes (273a, 273b), spaced apart in the first direction, and wherein the second supporting area is disposed between the pair of through holes.

10. The electronic device of claim 9, wherein the fixing member further includes a cutout (276) formed in the second supporting area, and
wherein the cutout is formed between the pair of through holes (273a, 273b) in at least one direction.

11. The electronic device of any one of claims 1 to 10, wherein the fixing member further includes a cutting area (275) in a portion of the first supporting area, and
wherein the cutting area is formed extending in the first direction in an area adjacent to an edge of the first supporting area.

12. The electronic device of any one of claims 1 to 11, wherein the second supporting area is spaced apart from the one surface (251) of the internal structure by a predetermined distance to define a height of the passage; and
wherein the predetermined distance is larger than or equal to a thickness of the flexible circuit board.

13. The electronic device of any one of claims 1 to 12, wherein the first supporting area is formed to surround at least a portion of an edge of the second supporting area.

14. The electronic device of any one of claims 1 to 13, wherein the internal structure includes a battery.

15. The electronic device (101) of claim 14, wherein the housing (210; 230) comprises a seating recess (235); and
the battery (250) is disposed in the seating recess.

## Patentansprüche

1. Elektronische Vorrichtung (101), umfassend:
ein Gehäuse (210; 230);
eine interne Struktur, die in dem Gehäuse vorgesehen ist;
ein Befestigungselement (270), das einen ersten Stützbereich (271), der an eine Oberfläche (251) der internen Struktur gekoppelt ist, und einen zweiten Stützbereich (272), der sich von dem ersten Stützbereich erstreckt, beinhaltet,
eine flexible Leiterplatte (230c; 243), die vorgesehen ist, um die eine Oberfläche (251) der internen Struktur in einer ersten Richtung zu kreuzen; und
wobei ein Abschnitt der flexiblen Leiterplatte durch einen Durchlass verläuft, der zwischen dem zweiten Stützbereich und der einen Oberfläche der internen Struktur gebildet ist.

2. Elektronische Vorrichtung nach Anspruch 1, wobei die interne Struktur, die flexible Leiterplatte und der zweite Stützbereich angeordnet sind, um in einem Bereich, in dem sie einander überlappen, nicht aneinander zu koppeln.

3. Elektronische Vorrichtung nach Anspruch 1 oder 2, wobei ein Klebematerial (274) zwischen zumindest einem Abschnitt des ersten Stützbereichs (271) und der einen Oberfläche (251) der internen Struktur vorgesehen ist.

4. Elektronische Vorrichtung nach einem der Ansprüche 1 bis 3, wobei der zweite Stützbereich (272) zumindest eine Öffnung (G1, G2) umfasst, durch welche die flexible Leiterplatte verläuft; und
wobei die flexible Leiterplatte in der ersten Richtung durch die zumindest eine Öffnung des zweiten Stützbereichs verschiebbar ist.

5. Elektronische Vorrichtung nach Anspruch 4, wobei die zumindest eine Öffnung des zweiten Stützbereichs ein Paar Öffnungen (G1, G2) umfasst, die in der ersten Richtung voneinander beabstandet sind.

6. Elektronische Vorrichtung nach Anspruch 5, wobei das Paar Öffnungen an zwei gegenüberliegenden Enden des Durchlasses in der ersten Richtung gebildet ist.

7. Elektronische Vorrichtung nach Anspruch 6, wobei ein Abschnitt des ersten Stützbereichs mit einer Kante des zweiten Stützbereichs in einer zweiten Richtung verbunden ist, welche die erste Richtung kreuzt und an die eine Oberfläche der internen Struktur gekoppelt ist.

8. Elektronische Vorrichtung nach Anspruch 4 bis 7, wobei die zumindest eine Öffnung zwischen einem Abschnitt des zweiten Stützbereichs und der einen Oberfläche der internen Struktur gebildet ist.

9. Elektronische Vorrichtung nach Anspruch 1 bis 8, wobei die zumindest eine Öffnung ein Paar Durchgangslöcher (273a, 273b) beinhaltet, die in der ersten Richtung beabstandet sind, und wobei der zweite Stützbereich zwischen dem Paar Durchgangslöcher vorgesehen ist.

10. Elektronische Vorrichtung nach Anspruch 9, wobei das Befestigungselement ferner einen Ausschnitt (276) beinhaltet, der in dem zweiten Stützbereich gebildet ist, und
wobei der Ausschnitt zwischen dem Paar Durchgangslöcher (273a, 273b) in zumindest einer Richtung gebildet ist.

11. Elektronische Vorrichtung nach einem der Ansprüche 1 bis 10, wobei das Befestigungselement ferner einen Schneidbereich (275) in einem Abschnitt des ersten Stützbereichs beinhaltet, und
wobei der Schneidbereich sich in der ersten Richtung in einem Bereich benachbart zu einer Kante des ersten Stützbereichs erstreckend gebildet ist.

12. Elektronische Vorrichtung nach einem der Ansprüche 1 bis 11, wobei der zweite Stützbereich von der einen Oberfläche (251) der internen Struktur um einen vorbestimmten Abstand beabstandet ist, um eine Höhe des Durchlasses zu definieren; und
wobei der vorbestimmte Abstand größer als oder gleich einer Dicke der flexiblen Leiterplatte ist.

13. Elektronische Vorrichtung nach einem der Ansprüche 1 bis 12, wobei der erste Stützbereich gebildet ist, um zumindest einen Abschnitt einer Kante des zweiten Stützbereichs zu umgeben.

14. Elektronische Vorrichtung nach einem der Ansprüche 1 bis 13, wobei die interne Struktur eine Batterie beinhaltet.

15. Elektronische Vorrichtung (101) nach Anspruch 14, wobei das Gehäuse (210; 230) eine Sitzvertiefung (235) umfasst; und
die Batterie (250) in der Sitzvertiefung vorgesehen ist.

## Revendications

1. Dispositif électronique (101) comprenant :
un boîtier (210 ; 230) ;
une structure interne disposée dans le boîtier ;
un élément de fixation (270) comprenant une première zone de support (271) couplée à une surface (251) de la structure interne et une seconde zone de support (272) s'étendant à partir de la première zone de support,
une carte de circuit souple (230c ; 243) disposée pour croiser la surface (251) de la structure interne dans une première direction ; et
une partie de la carte de circuit souple passant à travers un passage formé entre la seconde zone de support et la première surface de la structure interne.

2. Dispositif électronique de la revendication 1, ladite structure interne, ladite carte de circuit souple et ladite seconde zone de support étant agencées de façon à ne pas se coupler l'une à l'autre dans une zone où elles se chevauchent.

3. Dispositif électronique de la revendication 1 ou 2, un matériau adhésif (274) étant disposé entre au moins une partie de la première zone de support (271) et la surface (251) de la structure interne.

4. Dispositif électronique de l'une quelconque des revendications 1 à 3, ladite seconde zone de support (272) comprenant au moins une ouverture (G1, G2) à travers laquelle la carte de circuit souple passe ; et
ladite carte de circuit souple pouvant être déplacée dans la première direction à travers l'au moins une ouverture de la seconde zone de support.

5. Dispositif électronique de la revendication 4, ladite au moins une ouverture de la seconde zone de support comprenant une paire d'ouvertures (G1, G2) espacées l'une de l'autre dans la première direction.

6. Dispositif électronique de la revendication 5, ladite paire d'ouvertures étant formée au niveau de deux extrémités opposées du passage dans la première direction.

7. Dispositif électronique de la revendication 6, une partie de la première zone de support étant raccordée à un bord de la seconde zone de support dans une seconde direction croisant la première direction et couplée à la surface de la structure interne.

8. Dispositif électronique de la revendication 4 à 7, ladite au moins une ouverture étant formée entre une partie de la seconde zone de support et la surface de la structure interne.

9. Dispositif électronique des revendications 1 à 8, ladite au moins une ouverture comprenant une paire de trous traversants (273a, 273b), espacés l'un de l'autre dans la première direction, et ladite seconde zone de support étant disposée entre la paire de trous traversants.

10. Dispositif électronique de la revendication 9, ledit élément de fixation comprenant en outre une découpe (276) formée dans la seconde zone de support, et
ladite découpe étant formée entre la paire de trous traversants (273a, 273b) dans au moins une direction.

11. Dispositif électronique de l'une quelconque des revendications 1 à 10, ledit élément de fixation comprenant en outre une zone de coupe (275) dans une partie de la première zone de support, et
ladite zone de coupe étant formée s'étendant dans la première direction dans une zone adjacente à un bord de la première zone de support.

12. Dispositif électronique de l'une quelconque des revendications 1 à 11, ladite seconde zone de support étant espacée de la surface (251) de la structure interne d'une distance prédéfinie pour définir une hauteur du passage ; et
ladite distance prédéfinie étant supérieure ou égale à une épaisseur de la carte de circuit souple.

13. Dispositif électronique de l'une quelconque des revendications 1 à 12, ladite première zone de support étant formée pour entourer au moins une partie d'un bord de la seconde zone de support.

14. Dispositif électronique de l'une quelconque des revendications 1 à 13, ladite structure interne comprenant une batterie.

15. Dispositif électronique (101) de la revendication 14, ledit boîtier (210 ; 230) comprenant un évidement de siège (235) ; et
ladite batterie (250) étant disposée dans l'évidement de siège.
